# EUROPEAN PATENT APPLICATION

(11) **EP 4 723 837 A1**
(43) Date of publication of application: **08.04.2026**
(21) Application number: 25198197.3
(22) Date of filing: 26.08.2025
(51) Int. Cl.: H10D 89/60, H02H 9/04

(54) **ESD CIRCUIT WITH ESD RAIL DISCHARGE CIRCUITRY**

(30) Priority: 02.10.2024 US 202418904205
(71) Applicant: NXP B.V., 5656 AG Eindhoven (NL)
(72) Inventor: Quax, Guido Wouter Willem, 5656 AG Eindhoven (NL); Anderson, Alma, 5656 AG Eindhoven (NL)
(74) Representative: Schmütz, Christian Klaus Johannes

(57) **Abstract**

An electrostatic discharge circuit for a semiconductor die includes a discharge circuit including a discharge path between an ESD rail and a lower supply voltage rail for carrying current between the ESD rail and the lower supply voltage rail to reduce the voltage of the ESD rail. The discharge circuit including a plurality of control devices, wherein each control device of the plurality of control devices is located in the discharge path to control the flow of current through the discharge path. Each control device of the plurality of control devices includes a control terminal that is coupled to a respective supply voltage terminal of a plurality of supply voltage terminals.

## Description

### BACKGROUND OF THE INVENTION

### Field of the Invention

This invention relates to discharge circuitry for an ESD circuit.

### Background

A semiconductor die may utilize electrostatic discharge (ESD) circuitry for protecting circuity of the semiconductor die from an ESD event affecting a die terminal.

An ESD event may occur when a charged object (e.g., a human finger) inadvertently contacts a conductive surface of a semiconductor die (e.g., a die terminal such as a contact pad, post, or bump) or a conductive surface of a semiconductor die package coupled to the die terminal where charge at an elevated voltage is applied to the conductive surface due to the contact. Being at an elevated voltage, such charge may cause voltage differentials across the devices of the die that may exceed their safe operating areas and damage those devices. An ESD event may also occur when a charged conductive surface of a circuit contacts an external object where charge is transferred between the conductive surface and the external object.

### BRIEF DESCRIPTION OF THE DRAWINGS

The present invention may be better understood, and its numerous objects, features, and advantages made apparent to those skilled in the art by referencing the accompanying drawings.
Figure 1 is a circuit diagram of circuitry of a prior art semiconductor die.
Figure 2 is a circuit diagram of circuitry of a semiconductor die including ESD circuitry according to one embodiment of the present invention.
Figure 3 is a circuit diagram of discharge circuitry according to one embodiment of the present invention.

The use of the same reference symbols in different drawings indicates identical items unless otherwise noted. The Figures are not necessarily drawn to scale.

### DETAILED DESCRIPTION

The following sets forth a detailed description of a mode for carrying out the invention. The description is intended to be illustrative of the invention and should not be taken to be limiting.

As disclosed herein, an electrostatic discharge circuit for a semiconductor die includes a discharge circuit including a discharge path between an ESD rail and a lower supply voltage rail for carrying current between the ESD rail and the lower supply voltage rail to reduce the voltage of the ESD rail. The discharge circuit including a plurality of control devices, wherein each control device of the plurality of control devices is located in the discharge path to control the flow of current through the discharge path. Each control device of the plurality of control devices includes a control terminal that is coupled to a respective supply voltage terminal of a plurality of supply voltage terminals.

In some embodiments, providing a discharge circuit including a discharge path between an ESD rail and a lower supply voltage rail that includes a plurality of control devices, where each control device includes a control terminal coupled to a respective supply voltage terminal, may provide for a discharge circuit that discharges current to set a maximum voltage on the ESD rail that is based on the volage of the supply voltage terminal of a die with the highest voltage. Such a circuit may be advantageous for subsequent effective operation of the ESD circuitry of the die after an ESD event such as after an ESD event due to a stress test.

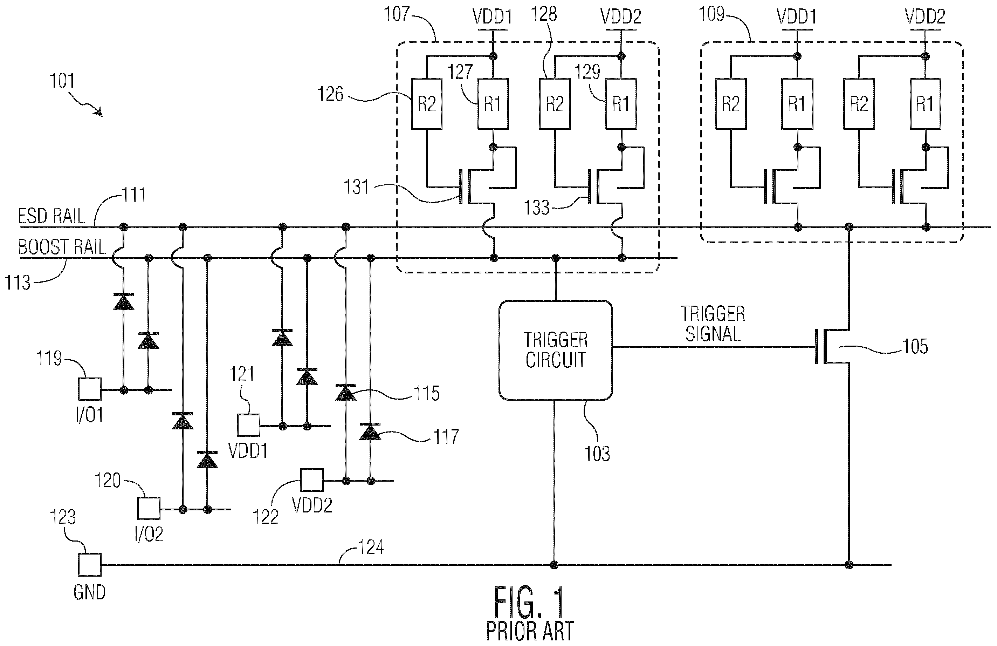

Figure 1 is a circuit diagram of circuitry of a prior art semiconductor die 101 that includes ESD circuitry. Die 101 includes supply voltage die terminals 121, 122, and 123 that are biased by supply voltages VDD1, VDD2, and GND, respectively, and includes I/O die terminals 119 and 120, which are configured to carry I/O signals. Die 101 includes an ESD rail 111 and an ESD boost rail 113. Die terminals 119, 120, 121, and 122 are each coupled to both ESD rail 111 and ESD boost rail 113 through a diode (e.g., terminal 122 is coupled to rail 111 through diode 115 and terminal 122 is coupled to rail 113 through diode 117). An ESD trigger circuit 103 is coupled to ESD boost rail 113 and ground rail 124, which is connected to die terminal 123. The trigger circuit detects on boost rail 113 an ESD event affecting one of die terminals 119-121, and in response asserts a trigger signal to make clamp device 105 conductive to discharge ESD current from the affected terminal (119-122), through ESD rail 111, to ground rail 124.

Semiconductor die 101 includes two highest of circuits 107 and 109. Highest of circuit 107 is coupled to boost rail 113 and is used to provide a bias voltage to rail 113 based on the highest of supply voltages VDD1 and VDD2, supplied by terminals 121 and 122, respectively. Highest of circuit 107 includes an NFET 131 whose source is coupled to VDD1 terminal 121 through resistor 126 and whose gate is coupled to VDD1 terminal 121 thought resistor 127. Highest of circuit 107 includes an NFET 133 whose source is coupled to VDD2 terminal 122 through resistor 129 and whose gate is coupled to VDD2 terminal 122 thought resistor 128. During normal operation, highest of circuit 107 is configured to provide a bias voltage to rail 113 at a voltage that is a voltage drop (e.g. -300 mV) below the highest voltage of VDD1 or VDD2. Highest of circuit 109 is of a similar construction to highest of circuit 107 and is coupled to rail 111. Circuit 109 is used to provide a bias voltage to rail 111 at a voltage based on the higher voltage of VDD1 or VDD2, supplied by terminals 121 and 122, respectively.

After an ESD event where clamp device 105 transitions from being conductive (to discharge ESD current) to being nonconductive, the voltage of rail 111 and/or rail 113 may be elevated above the highest voltage of VDD1 and VDD2 due to not all of the ESD charge being discharged through clamp device 105 or through trigger circuit 103 during an ESD event. With a higher than expected voltage on rails 111 or 113, the operation of the trigger circuit 103 and clamp device 105 may be adversely affected. For example, if rail 113 is at a higher voltage than expected, it may cause trigger circuit 103 to erroneously assert the trigger signal. If rail 111 is at a higher voltage than expected, clamp device 105 may not become conductive during an ESD event. This may be an issue during ESD stress testing when the die terminals maybe subject to multiple ESD event tests. Accordingly, it may be important in some embodiments to ensure that ESD rail 111 and ESD rail 113 have a voltage that is within a defined window for providing proper ESD protection.

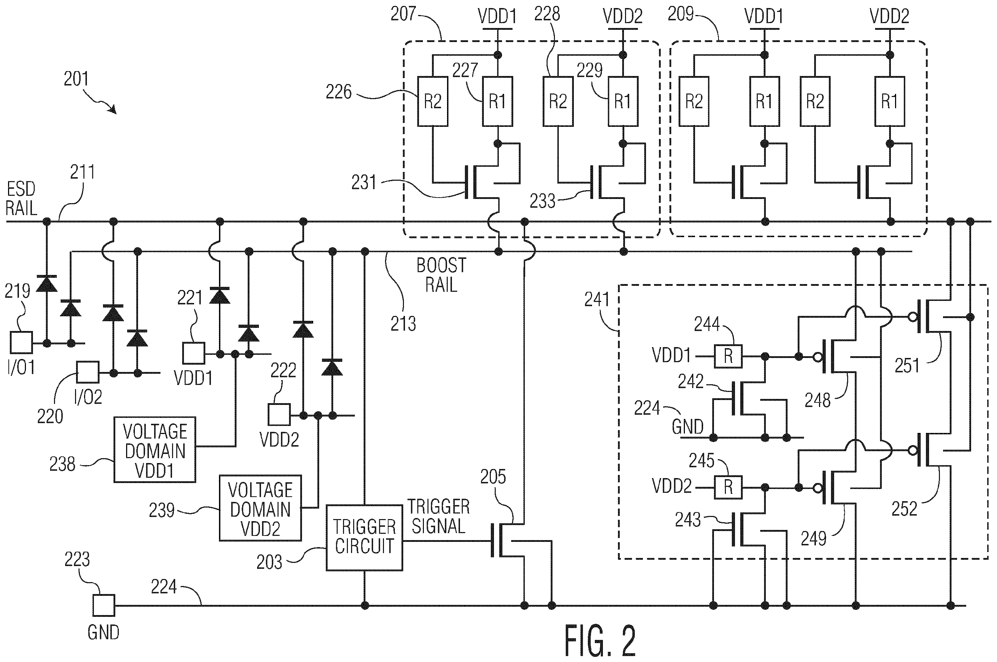

Figure 2 is a circuit diagram of circuitry of a semiconductor die 201 that includes ESD circuitry according to one embodiment of the present invention. Die 201 includes supply voltage die terminals 221, 222, and 223 that are biased by supply voltages VDD1, VDD2, and GND, respectively, and I/O terminals 219 and 220, which are configured to carry input signals and/or output signals.

Die terminals 219-223 are configured to provide signals and supply voltages to other circuitry of die 201. Supply voltage die terminal 221 supplies a supply voltage VDD1 to voltage domain VDD1 238, and supply voltage die terminal 222 supplies a supply voltage VDD2 to voltage domain VDD2 239. Voltage domain VDD1 238 and voltage domain VDD2 239 represent other circuitry of die 201 in those voltage domains. In some embodiments, the supply voltages VDD1 and VDD2 provided to the voltage domains can vary during operation to implement power modes of the circuitry of the die and/or when at least some of the supply voltages are supplied by a battery where the supply voltage can vary with charge level. In some embodiments, VDD1 and VDD2 are different voltages, but in other embodiments, VDD1 and VDD2 can be of the same, at least during some modes of operation. In some embodiments, a die may include multiple supply voltage die terminals that receive a supply voltage for a voltage domain that are coupled to a common supply voltage rail of the die.

In some embodiments, the other circuitry of die 201 includes one of more types of circuits such as e.g., analog, digital, mix signal, buffer, processor, memory, sensor, power, discrete, and/or wireless circuitry. Semiconductor die 201 may be packaged in a packaging material (e.g., molding compound, epoxy, or plastic (not shown)) by itself or with other die or electronic devices (not shown) to form a semiconductor die package (not shown) that is implemented in any one of a number of systems such as e.g., computers, cell phones, automotive electronics, wearables, IOT systems, industrial control equipment, embedded systems, or communications equipment. The die terminals 219-223 are coupled to external package terminals (e.g., such as solder balls, pads, posts, or leads (not shown)) such that the ESD circuity shown in Figure 2 may be activated during an ESD event affecting those package terminals.

Die 201 includes an ESD rail 211 and an ESD boost rail 213. Die terminals 219, 220, 221, and 222 are each coupled to both ESD rail 211 and ESD boost rail 213 through a diode (e.g., terminal 222 is coupled to rail 211 through diode 215 and terminal 222 is coupled to rail 213 through diode 217). An ESD trigger circuit 203 is coupled to ESD boost rail 213 and ground rail 224, which is connected to die terminal 223. The trigger circuit 203 detects an ESD event of a sufficient severity on rail 213 affecting one of die terminals 219-222, and in response, asserts and trigger signal to make clamp device 205 conductive to discharge ESD current from the affected terminal (219-222), through ESD rail 211, to ground rail 224. In the embodiment shown, clamp device 205 is implemented with an NFET transistor having a gate connected to receive the trigger signal, a source connected to ESD rail 211, and a drain and body terminal connected to rail 224. However, other types of clamp devices may be used in other embodiments including other types of transistors, multiple transistors, and/or including other devices. In some embodiments, trigger circuit 203 asserts the trigger signal based on an RC time constant implemented in circuit 203. In other embodiments, the trigger signal may also be asserted when a rail voltage exceeds a voltage level. However, other types of trigger circuits may be used in other embodiments.

Semiconductor die 201 includes two highest of circuits 207 and 209. Highest of circuit 207 is coupled to boost rail 213 and is used to provide a bias voltage to rail 213 at a voltage based on the highest of supply voltages VDD1 and VDD2, supplied by terminals 221 and 222, respectively. Highest of circuit 207 includes an NFET 231 whose source is coupled to VDD1 terminal 221 through resistor 226 and whose gate is coupled to VDD1 terminal 221 thought resistor 227. Highest of circuit 207 includes an NFET 233 whose source is coupled to VDD2 terminal 222 through resistor 229 and whose gate is coupled to VDD2 terminal 222 thought resistor 228. During normal operation, highest of circuit 207 is configured to provide a bias voltage to rail 213 at a voltage that is a voltage drop below the highest voltage of VDD1 or VDD2, supplied by terminals 221 and 222, respectively. Highest of circuit 209 is of a similar construction to circuit 207 and is coupled to rail 211. Circuit 209 is used to provide a bias voltage to rail 211 at a voltage that is a voltage drop below the highest voltage of VDD1 or VDD2. In some embodiments, based on the configuration of the highest of circuits, the voltage drop of the highest of circuits 207 and 209 is approximately 300 mV, but may be of different values in other embodiments. The bias voltages from the highest of circuits 209 and 207 set a minimum voltage of rails 211 and 213, respectively, during normal operation. Other embodiments may have highest of circuits of other configurations and/or include other devices (e.g. diodes). In some embodiments resistors 226-229 have a resistance in the range of 100-10K ohms, but may be of other resistances (e.g., 100K ohms) in other embodiments. Some embodiments may not include highest of circuits.

Die 201 includes a discharge circuit 241. Discharge circuit 241 includes a discharge path that includes PFETs 248 and 249 connected in series between ESD boost rail 213 and rail 224 for lowering the voltage on rail 213 after an ESD event. In the embodiment shown, PFETs 248 and 249 act as control devices for controlling the conductivity of the discharge path. PFET 248 includes a gate coupled to VDD1 terminal 221 through resistor 244, a source connected to rail 213, a drain connected to the source of PFET 249, and a body terminal connected to rail 213. PFET 249 includes a gate coupled to VDD2 terminal 222 through resistor 245, a drain connected to ground rail 224, and a body terminal connected to rail 213. The body regions of PFET 248 and 249 are located in a common N-well of the substrate of die 201 that is biased by rail 213.

Discharge circuit 241 includes another discharge path that includes PFETs 251 and 252 connected in series between ESD rail 211 and rail 224 for lowering the voltage on rail 211 after an ESD event. PFETs 251 and 252 act as control devices for controlling the conductivity of the discharge path. PFET 251 includes a gate coupled to VDD1 terminal 221 through resistor 244, a source connected to rail 211, a drain connected to the source of PFET 252, and a body terminal connected to rail 211. PFET 252 includes a gate coupled to VDD2 terminal 222 through resistor 245, a drain connected to ground rail 224, and a body terminal connected to rail 211. The body regions of PFETs 251 and 252 are located in common N-well in the substrate of die 201 that is biased by rail 211.

Discharge circuit 241 includes NFET 242 that is in a grounded gate configuration where its drain is connected to the gates of PFETs 248 and 251 and its gate, source, and body terminal are connected to GND rail 224. NFET 242 protects PFETs 248 and 251 from an ESD event affecting die terminal 221. Discharge circuit 241 includes NFET 243 that is in a grounded gate configuration where its drain is connected to the gates of PFETs 249 and 252 and its gate, source, and body terminal are connected to GND rail 224. NFET 243 protects PFETs 249 and 252 from an ESD event affecting die terminal 222. In one embodiment, resistors 244 and 245 have a resistance in the range of 50-5000 ohms, but may be of different resistances in other embodiments.

During operation, PFET 248 becomes conductive when the voltage of ESD boost rail 213 exceeds the supply voltage VDD1 plus a threshold voltage of PFET 248 (e.g., .4 V), (e.g., the voltage of rail 213 exceeds VDD1 +.4 V). PFET 249 becomes conductive when PFET 248 is conductive and the voltage of ESD boost rail 213 exceeds supply voltage VDD2 plus the threshold voltage of PFET 249 (e.g., .4 V), (e.g., the voltage of rail 211 exceeds VDD2 +.4 V). In other embodiments, the PFETs may have other threshold voltages, depending upon FET characteristics such as e.g., gate oxide thickness and doping concentrations.

Thus, current from rail 213 to rail 224 is discharged through PFETs 248 and 249 only when the voltage on rail 213 is at least a threshold voltage of PFET 248 above supply voltage VDD1 and at least a threshold voltage of PFET 249 above supply voltage VDD2. If the threshold voltages of PFETs 248 and 249 are equal, the discharge path will stop conducting once the voltage of rail 213 falls to a voltage less than the threshold voltage above the higher of VDD1 or VDD2 to make PFET 248 nonconductive (if VDD1 is higher) or to make PFET 249 nonconductive (if VDD2 is higher). In this way, the discharge path of PFETs 248 and 249 sets a maximum voltage of ESD boost rail 213 during normal operation.

During operation, PFET 251 becomes conductive when the voltage of ESD rail 211 exceeds the supply voltage VDD1 plus a threshold voltage of PFET 251 (e.g., .4 V), (e.g., exceeds VDD1 +.4 V), and PFET 252 becomes conductive when PFET 251 is conductive and the voltage of ESD rail 211 exceeds the supply voltage VDD2 plus the threshold voltage of PFET 252 (e.g., .4 V), (e.g., exceeds VDD2 + .4 V).

Thus, current from rail 211 to rail 224 is discharged through PFETs 251 and 252 only when the voltage on rail 211 is at least a threshold voltage of PFET 251 above supply voltage VDD1 and at least a threshold voltage of PFET 252 above supply voltage VDD2. If the threshold voltages of PFETs 251 and 252 are equal, the discharge path will stop conducting once the voltage of rail 211 falls to a voltage less than the threshold voltage above the higher of VDD1 or VDD2 to make PFET 251 nonconductive (if VDD1 is higher) or PFET 252 nonconductive (if VDD2 is higher). In this way, the discharge path of PFETs 251 and 252 sets a maximum voltage of ESD rail 211 during normal operation.

Working in combination, the highest of circuits 207 and 209 and discharge circuit 241 operate to set a voltage window for both ESD rail 211 and ESD boost rail 213 during normal operations based on the highest voltage of VDD1 and VDD2. The highest of circuits 207 and 209 operate to set a minimum voltage of rails 211 and 213 at a voltage drop (e.g. -300 mV) below the highest voltage of VDD1 and VDD2. Discharge circuit 241 sets a maximum voltage of rails 211 and 213 at the threshold voltage of a PFET ( e.g., .4 V) above the highest voltage of VDD1 and VDD2.

Consequently, discharge circuit 241 can be used to effectively set a maximum voltage even if some of the voltage domains are turned off or otherwise at a lower voltage due to being placed in a low power mode. For example, if the voltage domain of VDD1 is powered down to where VDD1 is at zero volts, then PFETs 248 and 251 would become conductive and the maximum voltage would be set to VDD2 plus the threshold voltage of a PFET.

One advantage in some embodiments of using PFETs (e.g., 248, 251) as a control device in the discharge circuit is that if a supply voltage is reduced or brought to zero volts while other the other supply voltages remain at their normal operational states, the PFET coupled to that reduced supply voltage becomes conductive. In addition, in some embodiments, if the supply voltages are reduced to zero volts, the ESD rails 211 and 213 will be discharged to zero volts since PFETs 248, 249, 251, and 252 would be conducting. Although in other embodiments, other types of control devices such as NFETs or other types of transistors could be used with different circuit configurations.

Other embodiments may include ESD circuitry of other configurations, including other configurations of discharge circuit 241. For example, in some embodiments, the discharge circuit only discharges current from one ESD rail (e.g., either rail 211 or rail 213). In some embodiments, ESD rail 211 and ESD bus rail 213 would be configured to be coupled to more than just two supply voltages. Also, in some embodiments, the transistors used as control devices may have different threshold voltages to provide a different maximum voltage buffer for each supply voltage. For example, in Figure 2, PFET 248 may have a threshold voltage of .4 V and PFET 249 may have a threshold of .5 V. Thus, if VDD2 were the highest supply voltage, then the maximum voltage would be VDD2 + .5 V wherein if VDD1 where the highest supply voltage, then the maximum voltage would be VDD1 + .4 V. Also, in other embodiments, other devices such as diodes and resistors may be located in the discharge paths, which in some embodiments, may affect the discharge threshold voltage of the discharge path.

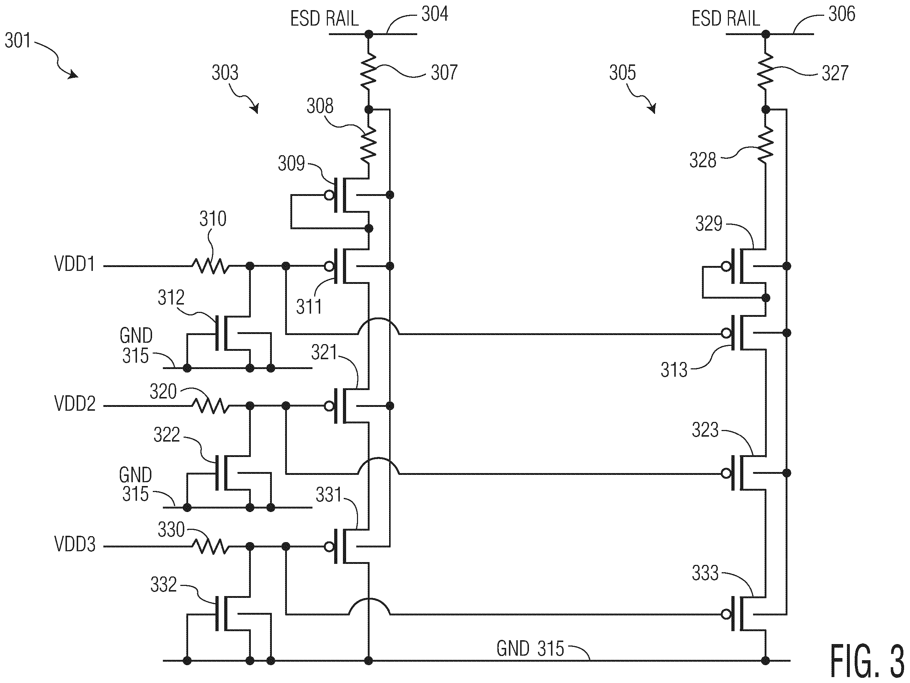

Figure 3 is an alternative embodiment of a discharge circuit according to another embodiment. Discharge circuit 301 includes two discharge paths 303 and 305. Discharge path 303 discharges current from ESD rail 304 and discharge path 305 discharges current from ESD rail 306. In one embodiment, one of ESD rail 304 or 306 is an ESD boost bus (e.g., like rail 213), however in other embodiments, a semiconductor die may include multiple ESD rails each with a clamp device (e.g., 205) coupled thereto for discharging current from the ESD rail.

In the embodiment shown, discharge path 303 includes three control device PFETs 311, 321, and 331 connected in series, where each PFET includes a gate coupled to receive a supply volage (VDD1, VDD2, VDD3, respectively) through a resistor (310, 320, 330, respectively). Discharge path 305 includes three control device PFETs 313, 323, and 333 connected in series, where each PFET includes a gate coupled to receive a supply volage (VDD1, VDD2, VDD3, respectively) through a resistor (310, 320, 330, respectively). Supply voltages VDD1, VDD2, VDD3 are supplied to three different voltage domains (not shown) of a semiconductor die.

An NFET 312 in a grounded gate configuration, includes a drain coupled to the gates of PFETs 311 and 313 and a source, gate, and body terminal connected to GND rail 315. NFET 312 protects PFETs 311 and 313 from an ESD event affecting the die terminal supplying VDD1. An NFET 322 in a grounded gate configuration, includes a drain coupled to the gates of PFETs 321 and 323 and a source, gate, and body terminal connected to GND rail 315. NFET 322 protects PFETs 321 and 323 from an ESD event affecting the die terminal supplying VDD2. An NFET 332 in a grounded gate configuration, includes a drain coupled to the gates of PFETs 331 and 333 and a source, gate, and body terminal connected to GND rail 315. NFET 332 protects PFETs 331 and 333 from an ESD event affecting the die terminal supplying VDD3.

Discharge path 303 includes resistor 307, resistor 308, and a diode configured PFET 309, which is connected in series between resistor 308 and PFET 311. Resistor 307 is connected to rail 304. When all three of PFETs 311, 321, and 331 are conductive due to an overvoltage condition on rail 304, current flows from ESD rail 304 through resistor 307, resistor 308, PFET 309, PFET 311, PFET 321, and PFET 331 to GND rail 315.

Discharge path 305 includes resistor 327, resistor 328, and a diode configured PFET 329, which is connected in series between resistor 328 and PFET 321. Resistor 327 is connected to rail 306. When all three of PFETs 313, 323, and 333 are conductive due to an overvoltage condition on rail 306, current flows from ESD rail 306 through resistor 327, resistor 328, PFET 329, PFET 313, PFET 323, and PFET 333 to GND rail 315.

Diode configured PFETs 309 and 329 are added to increase the discharge threshold voltages at which the discharge paths (303 and 305, respectively) will conduct in response to an over voltage condition, thereby increasing the maximum voltages of the rails (304 and 306, respectively) from the voltage of the highest supply voltage of VDD1, VDD2, and VDD3 by a diode voltage drop ( e.g., .4 V) of the diode configured PFETs (309, 329). For example, the maximum voltage on rail 304 or 306 will be the highest voltage of VDD1, VDD2, and VDD3, plus the threshold voltage of a PFET (PFETs 311, 321, 331, 313, 323, and 333) (e.g. .4 V), plus the diode voltage drop of a diode configured PFET (PFETs 309 and 329) (e.g., .4 V), plus a de minimis voltage drop of resistors 307 and 308 (or resistors 327 and 328) (e.g., .1 mV). An additional number of diode configured PFETs (or other types of diodes) can be added to the discharge path to increase the discharge threshold voltage of the path which increases the maximum voltage on a_rail with respect to the highest supply voltage. In other embodiments, PFETs 309 and 329 may be replaced with other types of diode devices such as a diode, which may provide a different voltage drop (e.g..7 V). In some embodiments, the discharge paths 303 and 305 may include a different number of diode devices from each other to provide a different maximum voltage on rails 304 and 306.

In one embodiment, resistors 307, 308, 327, and 328 have a resistance of 3K Ohms, but may be of other resistances in other embodiments. The body terminals for PFETs 309, 311, 321, and 331 are located in a common N well of the substrate of the semiconductor die that is biased by a node between resistor 307 and resistor 308. The body terminals for PFETs 329, 313, 323, and 333 are located in a common N well of the substrate of the semiconductor die that is biased by a node between resistor 327 and resistor 328. The N wells are biased at a node between the resistors (e.g., resistors 307 and 308) in the discharge paths so as to protect the well regions from ESD current during an ESD event. Also, the particular biasing configuration of the N wells may affect the threshold voltages of the PFETs in some embodiments. However, the PFETs may have different N well biasing configurations in other embodiments. In some embodiments, the discharge threshold voltage of a path may be slightly affected by the drain-source resistances of the PFETs in the discharge path (e.g. PFETs 311, 321, and 331), depending on device configuration.

Although Figure 3 shows three control devices (e.g., PFETs 311, 321, 331) in a discharge path (e.g., path 303), other embodiments may include a different number of control devices depending on the number of supply voltages.

Providing a discharge circuit for discharging charge on an ESD rail that includes multiple control devices in the discharge path where each control device is coupled to a different supply voltage terminal, may allow for in some embodiments for a circuit that can lower the voltage of an ESD rail after an ESD event (such as during a stress test) to within a maximum level that is dependent upon the highest supply voltage. Also, it may allow for the discharge of an ESD rail when all supply voltages are powered down. Such a circuit may allow for the proper operation of the ESD circuitry after multiple ESD events and during the switching of different power modes of the voltage domains.

As used herein, one item is "coupled" to another item in a path either by being connected to the other item or by being coupled in path through at least one further item. For example, in Figure 3, the drain of PFET 311 is coupled to rail 315 through the path of PFET 321 and PFET 331. The source of PFET 311 is coupled to the drain of PFET 309 by being connected to it. A gate is a control terminal of a FET. A drain and source are current terminals of a FET.

Features specifically shown or described with respect to one embodiment set forth herein may be implemented in other embodiments set forth herein.

In some embodiments, a semiconductor die includes a plurality of supply voltage die terminals. Each supply voltage die terminal of the plurality of supply voltage die terminals is configured to supply a supply voltage to a respective voltage domain of a plurality of voltage domains of the semiconductor die. The semiconductor die includes electrostatic discharge (ESD) circuity including a first ESD rail. Each supply voltage die terminal of the plurality of supply voltage die terminals is coupled to the first ESD rail. The ESD circuitry includes a discharge circuit including a discharge path between the first ESD rail and a lower supply voltage rail for carrying current between the first ESD rail and the lower supply voltage rail. The discharge circuit including a plurality of control devices. Each control device of the plurality of control devices is located in the discharge path to control the flow of current through the discharge path. Each control device of the plurality of control devices includes a control terminal that is coupled to a respective supply voltage die terminal of the plurality of supply voltage die terminals.

In further embodiments of the semiconductor die, current flows from the first ESD rail to the lower supply voltage rail through the discharge path when a voltage of the first ESD rail is higher by at least a discharge threshold voltage from a voltage of a supply voltage die terminal of the plurality of supply voltage die terminals having the highest voltage of the plurality of supply voltage die terminals.

In further embodiments of the semiconductor die, the discharge threshold voltage includes at least a threshold voltage of a field effect transistor.

In further embodiments of the semiconductor die, current flows from the first ESD rail to the lower supply voltage rail through the discharge path when all of the control devices of the plurality of control devices are in a conductive state.

In further embodiments of the semiconductor die, wherein the first ESD rail is coupled to a trigger circuit of the ESD circuitry that asserts a trigger signal to make an ESD clamp circuit of the ESD circuitry conductive in response to the trigger circuit detecting an ESD event affecting the first ESD rail.

In further embodiments of the semiconductor die, the first ESD rail is coupled to an ESD clamp circuit of the ESD circuitry that is made conductive during a detected ESD event to discharge ESD current from the first ESD rail to the lower supply voltage rail through the ESD clamp circuit.

In further embodiments of the semiconductor die, the each of the control devices of the plurality of control devices is characterized as a P-type transistor, wherein the control terminal of each P-type transistor of the plurality of control devices is coupled to a respective supply voltage die terminal of the plurality of supply voltage die terminals.

In further embodiments of the semiconductor die, each P-type transistor of the plurality of control devices includes a body region located in a common N type well region.

In further embodiments of the semiconductor die, each control device of the plurality of control devices is coupled in series in the discharge path.

In further embodiments, the semiconductor die includes at least one I/O die terminal coupled the first ESD rail.

In further embodiments, the semiconductor die includes a second ESD rail, each supply voltage die terminal of the plurality of supply voltage die terminals is coupled to the second ESD rail. The discharge circuit includes a second discharge path between the second ESD rail and the lower supply voltage rail for carrying current between the second ESD rail and the lower supply voltage rail, the discharge circuit including a second plurality of control devices, wherein each control device of the second plurality of control devices is located in the second discharge path to control the flow of current through the second discharge path, wherein each control device of the second plurality of control devices includes a control terminal that is coupled to a respective supply voltage die terminal of the plurality of supply voltage die terminals.

In further embodiments of the semiconductor die, the first ESD rail is coupled to a trigger circuit of the ESD circuitry that asserts a trigger signal to make an ESD clamp circuit of the ESD circuitry conductive in response to the trigger circuit detecting an ESD event affecting the first ESD rail. The second ESD rail is coupled to the ESD clamp circuit and is made conductive to discharge ESD current from the second ESD rail to the lower supply voltage rail through the ESD clamp circuit.

In further embodiments of the semiconductor die, during normal operation, the first ESD rail is supplied with a bias voltage that is determined by a supply voltage of a supply voltage die terminal of the plurality of supply voltage die terminals that is biased at the highest voltage.

In further embodiments, the semiconductor die includes a diode device located in the discharge path in series with the plurality of control devices.

In further embodiments of the semiconductor die, the ESD circuitry includes a highest of circuit, the highest of circuit is coupled to each supply voltage die terminal of the plurality of supply voltage die terminals, the highest of circuit is configured to supply a bias voltage to the first ESD rail, wherein during normal operation, the bias voltage is at a voltage lower by a voltage drop than a voltage of the supply voltage die terminal of the plurality of supply voltage die terminals at the highest voltage.

In other embodiments, a semiconductor die includes a plurality of supply voltage die terminals, each supply voltage die terminal of the plurality of supply voltage die terminals is configured to supply a supply voltage to a respective voltage domain of a plurality of voltage domains of the semiconductor die. The semiconductor die includes electrostatic discharge (ESD) circuity. The ESD circuitry includes a first ESD rail, each supply voltage die terminal of the plurality of supply voltage die terminals is coupled to the first ESD rail. The ESD circuitry includes a discharge circuit including a discharge path between first ESD rail and a lower supply voltage rail for carrying current between the first ESD rail and the lower supply voltage rail, the discharge circuit including a plurality of transistors located in series in the discharge path, wherein each transistor of the plurality of transistors is located in the discharge path to control the flow of current through the discharge path, wherein each transistor of the plurality of transistors includes a control terminal that is coupled to a respective supply voltage die terminal of the plurality of supply voltage die terminals.

In further embodiments of the semiconductor die, current flows from the first ESD rail to the lower supply voltage rail through the discharge path when a voltage of the first ESD rail is higher by at least a discharge threshold voltage from a voltage of a supply voltage die terminal having the highest voltage of the plurality of supply voltage die terminals.

In further embodiments of the semiconductor die, wherein current flows from the first ESD rail to the lower supply voltage rail through the discharge path when all of the transistors of the plurality of transistors are in a conductive state.

In other embodiments, a semiconductor die includes at least one I/O die terminal coupled to the first ESD rail, wherein during an ESD event affecting an I/O die terminal of the at least one I/O die terminal where the voltage of the first ESD rail is elevated above the voltages of all of the supply voltage die terminals of the plurality of supply voltage die terminals by at least a discharge threshold voltage, the discharge path becomes conductive to discharge current from the first ESD rail to the lower supply voltage rail.

In other embodiments, a semiconductor die includes a second ESD rail, each supply voltage die terminal of the plurality of supply voltage die terminals is coupled to the second ESD rail, a second discharge path between second ESD rail and a lower supply voltage rail for carrying current between the second ESD rail and the lower supply voltage rail, the second discharge path including a second plurality of transistors located in series in the second discharge path, wherein each transistor of the second plurality of transistors is located in the second discharge path to control the flow of current through the second discharge path, wherein each transistor of the second plurality of transistors includes a control terminal that is coupled to a respective supply voltage die terminal of the plurality of supply voltage die terminals.

While particular embodiments of the present invention have been shown and described, it will be recognized to those skilled in the art that, based upon the teachings herein, further changes and modifications may be made without departing from this invention and its broader aspects, and thus, the appended claims are to encompass within their scope all such changes and modifications as are within the scope of this invention.

## Claims

1. A semiconductor die, comprising:
a plurality of supply voltage die terminals, each supply voltage die terminal of the plurality of supply voltage die terminals is configured to supply a supply voltage to a respective voltage domain of a plurality of voltage domains of the semiconductor die;
electrostatic discharge (ESD) circuity including:
a first ESD rail, each supply voltage die terminal of the plurality of supply voltage die terminals is coupled to the first ESD rail;
a discharge circuit including a discharge path between the first ESD rail and a lower supply voltage rail for carrying current between the first ESD rail and the lower supply voltage rail, the discharge circuit including a plurality of control devices, wherein each control device of the plurality of control devices is located in the discharge path to control the flow of current through the discharge path, wherein each control device of the plurality of control devices includes a control terminal that is coupled to a respective supply voltage die terminal of the plurality of supply voltage die terminals.

2. The semiconductor die of claim 1 wherein current flows from the first ESD rail to the lower supply voltage rail through the discharge path when a voltage of the first ESD rail is higher by at least a discharge threshold voltage from a voltage of a supply voltage die terminal of the plurality of supply voltage die terminals having the highest voltage of the plurality of supply voltage die terminals.

3. The semiconductor die of claim 2 wherein the discharge threshold voltage includes at least a threshold voltage of a field effect transistor.

4. The semiconductor die of any of claims 1 to 3, wherein current flows from the first ESD rail to the lower supply voltage rail through the discharge path when all of the control devices of the plurality of control devices are in a conductive state.

5. The semiconductor die of any of claims 1 to 4, wherein the first ESD rail is coupled to a trigger circuit of the ESD circuitry that asserts a trigger signal to make an ESD clamp circuit of the ESD circuitry conductive in response to the trigger circuit detecting an ESD event affecting the first ESD rail.

6. The semiconductor die of any of claims 1 to 5, wherein the first ESD rail is coupled to an ESD clamp circuit of the ESD circuitry that is made conductive during a detected ESD event to discharge ESD current from the first ESD rail to the lower supply voltage rail through the ESD clamp circuit.

7. The semiconductor die of any of claims 1 to 6, wherein the each of the control devices of the plurality of control devices is characterized as a P-type transistor, wherein the control terminal of each P-type transistor of the plurality of control devices is coupled to a respective supply voltage die terminal of the plurality of supply voltage die terminals.

8. The semiconductor die of claim 7 wherein each P-type transistor of the plurality of control devices includes a body region located in a common N type well region.

9. The semiconductor die of any of claims 1 to 8, wherein each control device of the plurality of control devices is coupled in series in the discharge path.

10. The semiconductor die of any of claims 1 to 9, further comprising at least one I/O die terminal coupled the first ESD rail.

11. The semiconductor die of any of claims 1 to 10, further comprising:
a second ESD rail, each supply voltage die terminal of the plurality of supply voltage die terminals is coupled to the second ESD rail;
wherein the discharge circuit includes a second discharge path between the second ESD rail and the lower supply voltage rail for carrying current between the second ESD rail and the lower supply voltage rail, the discharge circuit including a second plurality of control devices, wherein each control device of the second plurality of control devices is located in the second discharge path to control the flow of current through the second discharge path, wherein each control device of the second plurality of control devices includes a control terminal that is coupled to a respective supply voltage die terminal of the plurality of supply voltage die terminals.

12. The semiconductor die of claim 11 wherein:
the first ESD rail is coupled to a trigger circuit of the ESD circuitry that asserts a trigger signal to make an ESD clamp circuit of the ESD circuitry conductive in response to the trigger circuit detecting an ESD event affecting the first ESD rail;
the second ESD rail is coupled to the ESD clamp circuit and is made conductive to discharge ESD current from the second ESD rail to the lower supply voltage rail through the ESD clamp circuit.

13. The semiconductor die of any of claims 1 to 12, wherein during normal operation, the first ESD rail is supplied with a bias voltage that is determined by a supply voltage of a supply voltage die terminal of the plurality of supply voltage die terminals that is biased at the highest voltage.

14. The semiconductor die of any of claims 1 to 13, further comprising a diode device located in the discharge path in series with the plurality of control devices.

15. The semiconductor die of any of claims 1 to 14, wherein the ESD circuitry includes a highest of circuit, the highest of circuit is coupled to each supply voltage die terminal of the plurality of supply voltage die terminals, the highest of circuit is configured to supply a bias voltage to the first ESD rail, wherein during normal operation, the bias voltage is at a voltage lower by a voltage drop than a voltage of the supply voltage die terminal of the plurality of supply voltage die terminals at the highest voltage.
